# EUROPÄISCHE PATENTSCHRIFT

(11) **EP 2 337 168 B1**
(45) Veröffentlichungstag und Bekanntmachung des Hinweises auf die Patenterteilung: **25.12.2019**
(21) Anmeldenummer: 10165592.6
(22) Anmeldetag: 10.06.2010
(51) Int. Cl.: H01S 5/14, H01S 5/04, H01S 5/183, H01S 5/026, H01S 5/40

(54) **Oberflächenemittierende Laserstrahlquelle mit zwei Kavitäten**
Two-cavity surface-emitting laser
Laser à émission par la surface et à deux cavités

(30) Priorität: 17.12.2009 US 287259 P
(43) Veröffentlichungstag der Anmeldung: 22.06.2011
(73) Patentinhaber: Forschungsverbund Berlin e.V., 12489 Berlin (DE)
(72) Erfinder: Tränkle, Günther, 12557 Berlin (DE)
(74) Vertreter: Gulde & Partner

(56) Entgegenhaltungen:
- EP-A1- 1 906 497
- EP-A2- 1 605 562
- WO-A1-2009/036728
- DE-A1- 10 129 616
- DE-A1- 10 243 545
- DE-A1-102006 011 284
- MICHAEL D GERHOLD ET AL: "Novel Design of a Hybrid-Cavity Surface-Emitting Laser" IEEE JOURNAL OF QUANTUM ELECTRONICS, IEEE SERVICE CENTER, PISCATAWAY, NJ, USA, Bd. 34, Nr. 3, 1. März 1998 (1998-03-01), XP011051874 ISSN: 0018-9197

## Beschreibung

Die vorliegende Erfindung betrifft eine oberflächen-emittierende Laserstrahlquelle bestehend aus einem vertikalen Resonator (Vertical-Cavity Surface-Emitting Laser, VCSEL) und einen senkrecht dazu in der Ebene der Halbleiterschichten angeordneten monolithisch integrierten Pump-Resonator (Two-Cavity Surface-Emitting Laser, TCSEL).

Ein VCSEL ist ein Halbleiterlaser, bei dem das Licht senkrecht zur Ebene des Halbleiterchips bzw. der aktiven Schicht abgestrahlt wird, im Gegensatz zum herkömmlichen Kantenemitter, bei dem das Licht an ein oder zwei Kanten des Chips austritt. Bei einem herkömmlichen VCSEL wird der Laserresonator durch zwei parallel zur Ebene des Wafers angeordnete DBR-Spiegel (Distributed Bragg-Reflector, nachfolgend auch Bragg-Reflektor genannt) gebildet, zwischen denen ein aktives Medium - üblicherweise mit einer oder mehreren Quantumtopfstrukturen - für die Erzeugung des Laserlichts eingebettet ist. Derartige planare DBR-Spiegel sind aus Schichten mit abwechselnd niedriger und hoher Brechzahl aufgebaut, die jeweils eine optische Dicke von einem Viertel der Laserwellenlänge (ResonanzWellenlänge der vertikalen Kavität) im Material (λ/4) haben. Dadurch werden die im VCSEL erforderlichen Reflektivitäten von über 99 % realisiert. Aufgrund der typischerweise kleinen Abmessungen des eigentlichen Lasers von nur wenigen Mikrometern in jeder Richtung haben VCSEL kleinere Ausgangsleistungen im Vergleich zu Kantenemittern. Es sind einerseits optisch gepumpte VCSEL, bei denen die aktive Zone von außen mit Licht kürzerer Wellenlänge zum Strahlen angeregt wird, und andererseits elektrisch gepumpte VCSEL, die eine p-i-n-Diode darstellen, bekannt. VCSEL für Wellenlängen zwischen 650 nm und 1200 nm basieren regelmäßig auf GaAs-Wafern, während bei Wellenlängen zwischen 1200 nm und 2000 nm zumindest die aktive Schicht (aktive Zone) auf GalnAsP oder GalnAsN basiert.

Das Dokument "Novel Design of a Hybrid-Cavity Surface-Emitting Laser" von Michael D. Gerhold et al., IEEE Journal of Quantum Electron., IEEE Service Center, Piscataway, NJ, USA, Bd. 34, Nr. 3, 1. März 1998 (1998-03-01), XP011051874,ISSN: 0018-9197 offenbart einen VCSEL mit einem aktiven Medium mit einem Emissionsmaximum bei einer ersten Wellenlänge, wobei ein erster Reflektor und ein zweiter Reflektor unterhalb uns oberhalb des aktiven Mediums angeordnet sind und ein Reflexionsmaximum im Bereich der ersten Wellenlänge aufweisen, und wobei ein dritter Reflektor und ein vierter Reflektor jeweils seitlich über oder neben dem aktiven Medium angeordnet sind, wobei der dritte Reflektor dem vierten Reflektor gegenüberliegt, und wobei die erste Wellenlänge kleiner als die Wellenlänge vom Pumplaser ist.

Weiterhin befasst sich WO 2009/036728 A1 mit einem strahlungsemittierenden Halbleiterbauelement mit vertikaler Emissionsrichtung, welches einen Pumpbereich aufweist und wobei die Seitenflächen des Pumpbereichs mit Bragg-Spiegeln versehen sein können.

Es ist daher Aufgabe der vorliegenden Erfindung, einen VCSEL anzugeben, der eine größere strahlende Fläche und damit höhere Ausgangsleistungen im Vergleich zu herkömmlichen VCSEL aufweist. Da eine größere strahlende Fläche jedoch kaum elektrisch gepumpt werden kann, soll der erfindungsgemäße TCSEL optisch durch einen integrierten horizontalen Laser mit einer durch ein eingebrachtes Gitter festgelegten Wellenlänge (zum Beispiel einen DBR-Laser) gepumpt werden, welcher seinerseits elektrisch gepumpt wird. Im Vergleich zu herkömmlichen VECSEL (vertical-external-cavity surface-emitting-laser), welche vertikal optisch gepumpt werden, zeichnet sich der erfindungsgemäße TCSEL durch eine einfachere Pumpgeometrie und insbesondere bessere Effizienz durch längere Absorptionslänge und geringeren Quantendefekt aus. Weiterhin soll die emittierte Laserstrahlung des erfindungsgemäßen TCSEL eine geringe Divergenz im Fernfeld aufweisen. Weiterhin soll der erfindungsgemäße TCSEL eine im Vergleich zu Kantenemittern bessere Strahlqualität, ein symmetrischeres Strahlprofil, und eine hohe Flächenskalierbarkeit aufweisen. Weiterhin soll der erfindungsgemäße TCSEL in einfacher Weise mit einem externen Resonator verwendet werden können.

Diese Aufgaben werden erfindungsgemäß durch einen TCSEL mit den im Patentanspruch 1 genannten Merkmalen gelöst. Bevorzugte Ausgestaltungen der Erfindung sind in den Unteransprüchen enthalten.

Der erfindungsgemäße TCSEL weist ein streifenförmiges, aktives Medium auf, mit dem stimulierte Emission in einem weiten Wellenlängenbereich erzeugt werden kann, konkret bei einer ersten Wellenlänge (Laserwellenlänge) und einer zweiten Wellenlänge (Pumpwellenlänge). Unterhalb des streifenförmigen, aktiven Mediums befindet sich zur Ausbildung einer integrierten vertikalen Kavität ein erster Reflektor und oberhalb des streifenförmigen, aktiven Mediums befindet sich ein zweiter Reflektor, wobei der erste Reflektor dem zweiten Reflektor gegenüberliegt und der erste Reflektor und der zweite Reflektor eine hohe Reflexion im Bereich der ersten Wellenlänge aufweisen. Zur Ausbildung einer integrierten Pumplaserkavität befindet sich weiterhin ein dritter Reflektor und ein vierter Reflektor, die (vorzugsweise jeweils seitlich des zweiten Reflektors) über oder neben dem streifenförmigen, aktiven Medium angeordnet sind, wobei der dritte Reflektor dem vierten Reflektor gegenüberliegt, und wobei der dritte Reflektor und der vierte Reflektor ein Reflexionsmaximum im Bereich einer zweiten Wellenlänge aufweisen (Pumpwellenlänge), wobei die Laserwellenlänge größer als die Pumpwellenlänge ist.

Vorzugsweise sind mindestens einer der Reflektoren als Bragg-Reflektor ausgebildet. Besonders bevorzugt sind alle Reflektoren als Bragg-Reflektor ausgebildet. Alternativ können die Reflektoren jedoch auch durch andere Reflektorarten ausgebildet sein. Das heißt, dass ein Reflektor, wenn der nachfolgend als Bragg-Reflektor bezeichnet wird, auch durch andere Reflektorarten ausgebildet sein kann. Beispielsweise muss der zweite Reflektor kein Bragg-Reflektor sein, sondern kann durch Metall ersetzt werden. Es ist ebenfalls bevorzugt, dass der zweite (Bragg-)Reflektor aus mehreren einzelnen optischen Elementen besteht, z.B. einem einfachen Spiegel (Spiegelschicht) und zusätzlich einem Bragg-Reflektor im Falle der externen VCSEL-Kavität. Weiterhin ist es bevorzugt, die Reflektivität des dritten (Bragg-)Reflektors und des vierten (Bragg-)Reflektors durch eine zusätzliche Beschichtung der planaren Halbleiterkanten zu erhöhen oder zu senken. Alternativ kann der horizontale Pumplaser auch als DFB-Laser (Distributed Feed Back) ausgeführt sein. Dann erstrecken sich der dritte Bragg-Reflektor und der vierten Bragg-Reflektor über den gesamten elektrisch gepumpten Bereich der Pump-Kavität.

Die Idee der Erfindung besteht darin, neben der an sich bekannten vertikalen Kavität eine zusätzliche integrierte (horizontale) Pump-Kavität auszubilden, die von zwei weiteren Bragg-Reflektoren bestimmt wird. Durch die Kombination beider Kavitäten und die geeignete Wahl der Wellenlängen kann so ein TCSEL mit einer besonders hohen Effizienz realisiert werden. Weiterhin vorteilhaft ist, dass die Integration horizontaler Spiegel die Verwendung nur eines aktiven Mediums zur Erzeugung sowohl der Pumpstrahlung als auch der langwelligeren VCSEL-Strahlung erlaubt. Das aktive Medium kann aus einer aktiven Schicht mit ein oder vorzugsweise mehreren Quantentöpfen bestehen oder auch aus mehreren, gleichen oder vorzugsweise unterschiedlichen aktiven Schichten mit jeweils ein oder vorzugsweise mehreren Quantentöpfen bestehen, die vorzugsweise in den Intensitätsmaxima der Kavität angeordnet sind.

Vorzugsweise erstreckt sich die Uniformität der aktiven Schichten über diejenige Länge der aktiven Schichten, die sich zwischen dem ersten und dem zweiten Reflektor (alternativ dem dritten und dem vierten Reflektor) befinden, noch bevorzugter über ihre gesamte Ausdehnung. Uniformität der aktiven Schicht im Sinne der vorliegenden Anmeldung bedeutet, dass die Schichtparameter (wie chemische Zusammensetzung, Dotierung, Schichtdicke) über die genannte Erstreckung relativ gesehen (Maximum zu Minimum) weniger als 10% voneinander abweichen.

Weiterhin kann die energetische Lage des Verstärkungsmaximums des aktiven Mediums im Pumplaser z. B. durch thermische Nachbehandlung gegenüber der energetischen Lage des Verstärkungsmaximums des aktiven Mediums im VCSEL verschoben sein.

Insbesondere ist es vorgesehen, dass die Laserwellenlänge (erste Wellenlänge) größer als die Pumpwellenlänge (zweite Wellenlänge) ist. Dies wird durch entsprechendes Ausbilden der vier planaren DBR-Spiegeln vorzugsweise derart erreicht, dass die beiden VCSEL-DBR-Spiegel (erster Bragg-Reflektor und zweiter Bragg-Reflektor) ihre Maximale Reflektivität im Bereich der VCSEL-Wellenlänge aufweisen, während die Pump-DBR-Spiegel (dritter Bragg-Reflektor und vierter Bragg-Reflektor) ihre Maximale Reflektivität im Bereich der (kleineren) Pumpwellenlänge aufweisen.

Erfindungsgemäß beträgt die Differenz zwischen der ersten Wellenlänge und der zweiten Wellenlänge zwischen 20 nm und 45 nm. Vorzugsweise ist die Differenz der Photonenenergie zwischen Pumpstrahlung und der nutzbaren vertikal emittierten Laserstrahlung kleiner 5%.

Erfindungsgemäß, um eine ungewünschte Rückkopplung zwischen den Pump-DBR-Spiegeln und den Photonen in der vertikalen Kavität (bei der VCSEL-Wellenlänge) zu vermeiden, beträgt die Bandbreite der Pump-DBR-Spiegel, innerhalb der die Reflektivität mehr als 50% der maximalen Reflektivität beträgt kleiner 5 nm In einer noch bevorzugten Ausführung ist diese Bandbreite kleiner 3 nm.

Vorzugsweise weisen der erste Bragg-Reflektor und der zweite Bragg-Reflektor jeweils eine Reflektivität von größer als 99%, noch bevorzugter größer als 99.8% für die erste Wellenlänge auf. Vorzugsweise besitzen erster Bragg-Reflektor und zweiter Bragg-Reflektor ihre maximale Reflektivität bei der ersten Wellenlänge. Vorzugsweise ist die Reflektivität des ersten Bragg-Reflektors für die erste Wellenlänge größer als die Reflektivität des zweiten Bragg-Reflektors für die erste Wellenlänge ist. Dadurch wird die VCSEL-Strahlung über den zweiten Bragg-Reflektor ausgekoppelt.

Vorzugsweise weisen der dritte Bragg-Reflektor und der vierte Bragg-Reflektor jeweils eine Reflektivität von größer als 60%, noch bevorzugter größer als 80%, noch bevorzugter größer als 99.9% für die zweite Wellenlänge auf. Vorzugsweise ist die Reflektivität des dritten Bragg-Reflektors bezüglich der zweiten Wellenlänge gleich der Reflektivität des vierten Bragg-Reflektors. Vorzugsweise besitzen dritter Bragg-Reflektor und vierter Bragg-Reflektor ihre maximale Reflektivität bei der zweiten Wellenlänge. Zur Anpassung der Reflektivität des dritten und vierten Bragg-Reflektors können auf die planaren Kanten des Halbleiters zusätzlich dielektrische Verspiegelungsschichten oder Entspiegelungsschichten aufgebracht sein.

Vorzugsweise ist der VCSEL auf einem GaAs-basierten Wafer aufgebaut. Das streifenförmige, aktive Medium weist vorzugsweise eine oder mehrere Schichten mit Dicken zwischen 3 nm und 100 nm, bevorzugter zwischen 5 nm und 10 nm und eine Länge zwischen 250 µm und 2500 µm, bevorzugter zwischen 1000 µm und 2000 µm auf.

Der lediglich optisch gepumpte Bereich zwischen den VCSEL-DBR-Spiegeln weist vorzugsweise eine Länge zwischen 500 µm und 100 µm, bevorzugter zwischen 250 µm und 150 µm auf. Der an beiden Seiten vorzugsweise unmittelbar angrenzende, elektrisch gepumpte Bereich, der zwar zwischen den Pump-DBR-Spiegeln aber nicht zwischen den VCSEL-DBR-Spiegeln liegt, weist vorzugsweise eine Länge zwischen 700 µm und 2000 µm, bevorzugter zwischen 1000 µm und 1500 µm auf. Die Breite des elektrisch gepumpten Bereichs beträgt vorzugsweise zwischen 500 µm und 100 µm, bevorzugter zwischen 250 µm und 150 µm.

Vorzugsweise schließen sich der dritte Bragg-Reflektor und der vierte Bragg-Reflektor direkt an das streifenförmige, aktive Medium an bzw. sind über ihm angeordnet.

Vorzugsweise kontaktiert das streifenförmige, aktive Medium an seiner Oberseite direkt eine erste Schicht aus einem halbleitenden Material und an seiner Unterseite direkt eine zweite Schicht aus einem halbleitenden Material, wobei die erste halbleitende Schicht in Bezug zur der zweiten halbleitenden Schicht eine Dotierung entgegengesetzter Polarität aufweist und beide aus mehreren Einzelschichten bestehen können. Vorzugsweise sind auf der Halbleiteroberfläche im gesamten elektrisch gepumpten Bereich des aktiven Mediums, d.h. zwischen den Pump-DBR-Spiegeln aber nicht im Bereich des zweiten VCSEL-DBR-Spiegels, Kontakte zur Injektion von Ladungsträgern vorgesehen. Die Halbleiterunterseite ist vorzugsweise mit einem ganzflächigen Kontakt versehen.

Besonders bevorzugt wird der erfindungsgemäße VCSEL mit einer externen Kavität verwendet. Dazu ist der erste Bragg-Reflektor direkt unterhalb der zweiten halbleitende Schicht angeordnet, wobei der zweite Bragg-Reflektor von der ersten halbleitenden Schicht beabstandet ist. Ein derart beweglicher zweiter Bragg-Reflektor erlaubt vorteilhafterweise eine Justierung der Laserwellenlänge. Bei der Beabstandung des zweiten Bragg-Reflektors von der ersten halbleitenden Schicht wird letztere vorzugsweise mit einer dielektrischen Schicht geschützt, die bevorzugt gleichzeitig zur Einstellung der Reflektivität an der Oberfläche der Halbleiterstruktur genutzt wird.

Der VCSEL-Bereich kann von einer, zwei oder auch mehr Pumplaserkavitäten gepumpt werden.

Die Erfindung wird nachfolgend anhand der in den Figuren dargestellten Ausführungsbeispiele näher erläutert.

Es zeigen:
- Fig. 1: einen erfindungsgemäßen TCSEL in schematischer, geschnittener Darstellung: Ausführungsbeispiel TCSEL A,
- Fig. 2: eine schematische Darstellung des Verstärkungsprofils des VCSEL aus Fig. 1 für unterschiedliche Ladungsträgerdichten in der aktiven Schicht,
- Fig. 3: eine schematische Darstellung der Ladungsträgerdichte in der aktiven Schicht entlang der horizontalen Achse in Fig. 1 bei geringer optischer Pumpleistung (gestrichelt) und bei hoher optischer Pumpleistung (durchgezogene Linie),
- Fig. 4: eine schematische Darstellung der Reflektivität in Abhängigkeit der Wellenlänge der Pump-DBR-Spiegel des TCSEL aus Fig. 1,
- Fig. 5: eine schematische Darstellung der Reflektivität in Abhängigkeit der Wellenlänge der VCSEL-DBR-Spiegel des TCSEL aus Fig. 1,
- Fig. 6: eine schematische Darstellung des Brechzahlprofils des VCSEL aus Fig. 1 entlang der vertikalen Achse,
- Fig. 7: eine schematische Darstellung der resonanten optischen Moden der vertikalen Kavität,
- Fig. 8: einen erfindungsgemäßen TCSEL in schematischer, geschnittener Darstellung: Ausführungsbeispiel TCSEL B,
- Fig. 9: einen erfindungsgemäßen TCSEL in schematischer, geschnittener Darstellung: Ausführungsbeispiel TCSEL C,
- Fig. 10: eine schematische Darstellung einer Draufsicht auf eine Anordnung von Pumplaser und VCSEL, Typ 1
- Fig. 11: eine schematische Darstellung einer Draufsicht auf eine Anordnung von Pumplaser und VCSEL, Typ 2
- Fig. 12: eine schematische Darstellung einer Draufsicht auf eine Anordnung von Pumplaser und VCSEL, Typ 3 , und
- Fig. 13: eine schematische Darstellung einer Draufsicht auf eine Anordnung von Pumplaser und VCSEL, Typ 4.

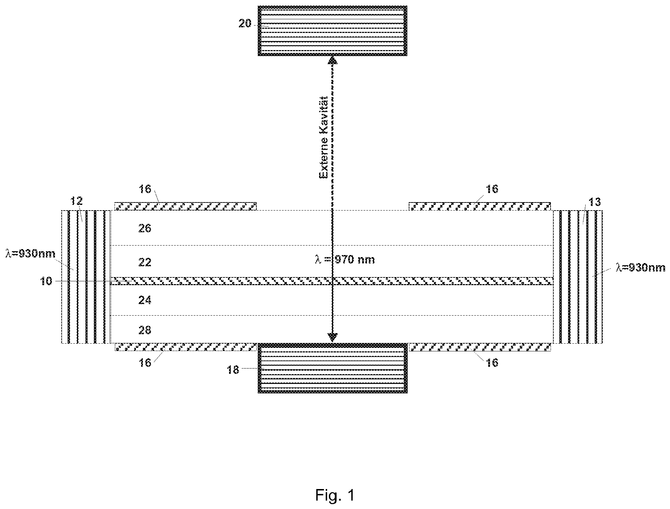

Fig. 1 zeigt einen TCSEL Querschnitt in der Ebene der Strahlausbreitung in beiden Kavitäten. Das aktive Medium 10 wird in horizontaler Richtung von den DBR-Regionen 12 und 13 begrenzt, welche den Resonator des horizontalen Pumplasers formen. Das aktive Medium 10 ist in vertikaler Richtung zwischen einem ersten Schichtpaket bestehend aus den halbleitenden Schichten 22 und 26 und einem zweiten Schichtpaket bestehend aus den halbleitenden Schicht 24 und 28 angeordnet, wobei das eine Schichtpaket n-dotiert und das andere p-dotiert ist. Im mittleren Bereich des TCSEL sind die Schichten 10, 22, 24, 26 und 28 zwischen den vertikalen DBR-Spiegeln 18 und 20 angeordnet. In den benachbarten Bereichen sind die halbleitenden Schichten 10, 22, 24, 26 und 28 zwischen elektrischen Kontaktschichten 16 angeordnet.

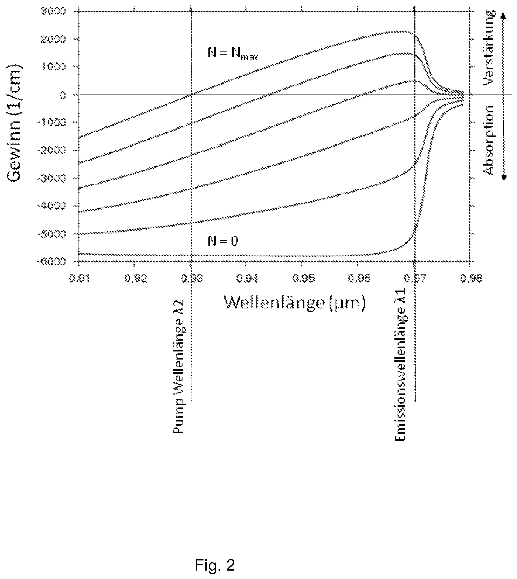

Fig. 2 zeigt Gewinn-Spektren der aktiven Schicht im zentralen VCSEL Bereich für unterschiedliche Ladungsträgerdichten N = 0...Nₘₐₓ. Ohne Pumpen, d.h. ohne Ladungsträger (N=0) absorbiert das aktive Medium im gesamten dargestellten Wellenlängenspektrum λ=910nm ... 980nm (negativer Gewinn). Mit zunehmender Pumpleistung und damit zunehmender Ladungsträgerdichte N entsteht positiver Gewinn zuerst in einem schmalen Spektralbereich nahe λ=970nm. Bei dieser ersten Wellenlänge λ1 soll die ResonanzWellenlänge (Emissionswellenlänge) der vertikalen Kavität liegen. Die Pumpwellenlänge λ2=930nm soll kürzer sein als λ1 damit das aktive Medium weiterhin Pumpleistung absorbiert. Wenn die Pumpleistung weiter zunimmt, steigt die Ladungsträgerdichte bis zum Maximalwert Nₘₐₓ an, bei dem keine Pumpstrahlung mehr absorbiert wird.

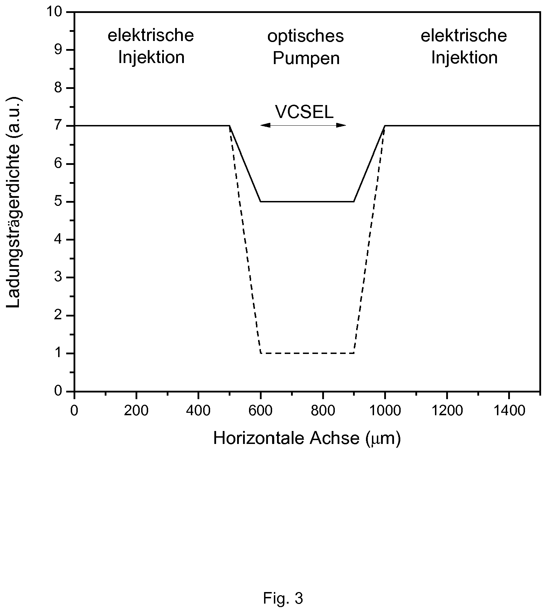

Fig. 3 zeigt schematisch das horizontale Profil der Ladungsträgerdichte in dem aktiven Medium 10 bei geringer optischer Pumpleistung (gestrichelt) und bei hoher optischer Pumpleistung (durchgezogene Linie). In den seitlichen Bereichen zwischen den elektrischen Kontakten 16 werden die Ladungsträger elektrisch injiziert. Im zentralen VCSEL Bereich werden die Ladungsträger optisch angeregt (gepumpt). Mit zunehmender optischer Pumpleistung steigt die Ladungsträgerdichte im VCSEL Bereich an bis der Maximalwert Nₘₐₓ erreicht wird. Die Ladungsträgerdichte im elektrisch injizierten Bereich liegt oberhalb von N-ₘₐₓ und bleibt annähernd konstant solange der Pumplaser oberhalb seiner Laserschwelle betrieben wird. Die laterale Ladungsträgerdiffusion ist vernachlässigbar.

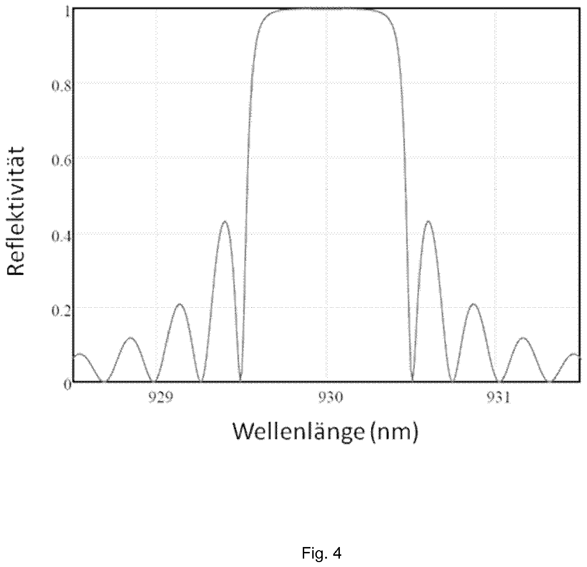

Fig. 4 zeigt das Reflektionsspektrum der horizontalen Bragg-Reflektoren 12 und 13 des Pumplasers. Die spektrale Breite des Reflektionsbandes ist sehr gering (hier etwa 1nm) was typisch ist für horizontale DBR Laser. Dieses schmale Reflektionsband nahe der Wellenlänge λ2=930nm ist ein wesentlicher Teil der Erfindung, da so eine horizontale Reflektion des VCSEL-Lichtes bei λ1=970nm ausgeschlossen wird.

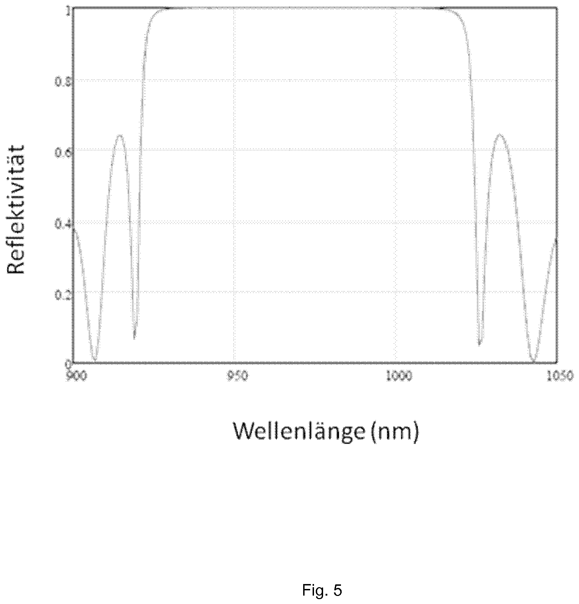

Fig. 5 zeigt das Reflektionsspektrum der vertikalen Bragg-Reflektoren 18 und 20 des VCSEL. Das Reflektionsband ist typischerweise recht breit (hier etwa 100nm). Durch vertikale Verschiebung des beweglichen DBR-Spiegels 20 kann die VCSEL Wellenlänge λ1 justiert werden.

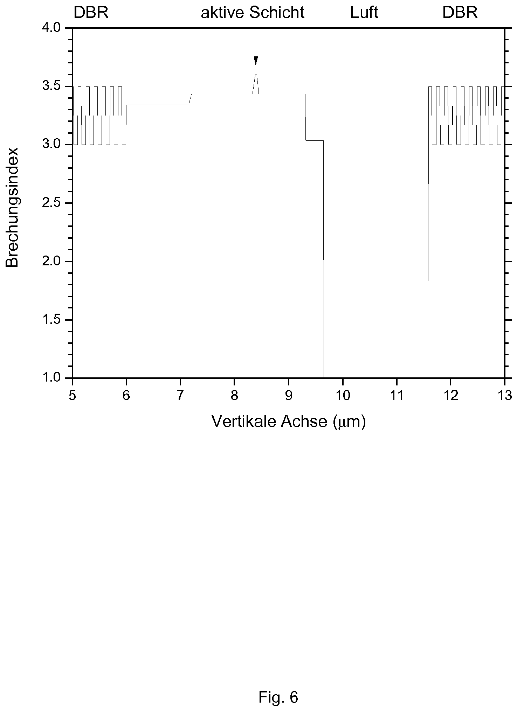

Fig. 6 zeigt das vertikale Profil des Brechungsindex im zentralen VCSEL Bereich. Die DBR-Spiegel 18 und 20 bestehen typischerweise aus zwei alternierenden Materialien mit vorzugsweise stark unterschiedlichen Werten des Brechungsindex. Der optische Abstand beider Spiegel 18, 20 bestimmt die Resonanzwellenlänge. Mit zunehmendem Abstand nimmt auch die Zahl der Resonanzwellenlängen zu, d.h., es können mehrere vertikale optische Moden existieren.

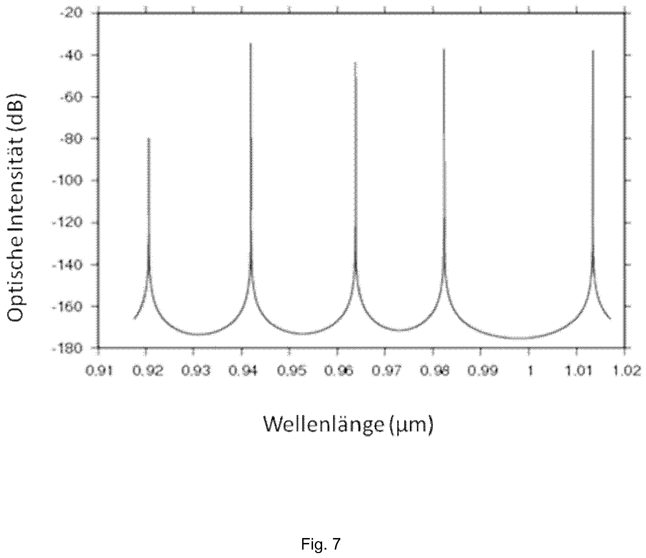

Fig. 7 zeigt schematisch das Spektrum der vertikalen optischen Moden des TCSEL. Die Mode (Wellenlänge) mit einem positiven optischen Gewinn ist die Lasermode (Emissionswellenlänge λ1 - siehe Fig. 2).

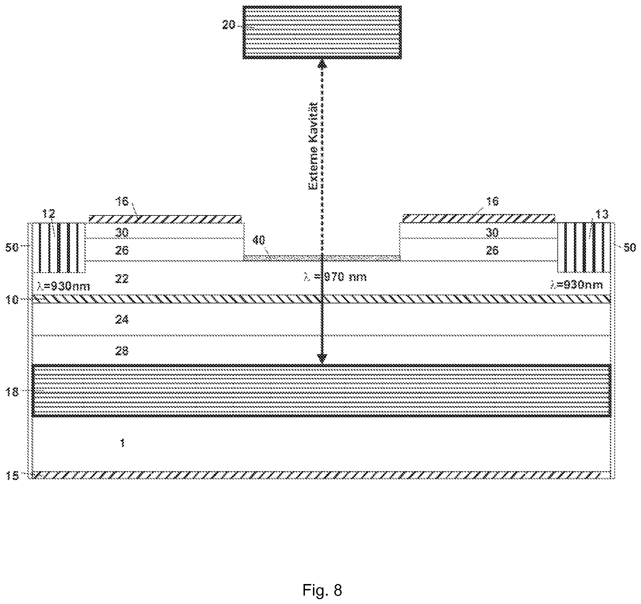

Fig. 8 zeigt den Querschnitt in der Ebene der Strahlausbreitung in beiden Kavitäten eines zweiten Ausführungsbeispieles B eines TCSEL. Beim Typ B ist der zweite Bragg-Spiegel 20 beabstandet, der erste Bragg-Spiegel 18 auf das mit Rückseitenkontakt 15 versehene Halbleitersubstrat 1 aufgebracht. Darüber befinden sich die n-Mantelschicht 28, die n-Wellenleiterschicht 24, das aktive Medium 10, die p-Wellenleiterschicht 22, die p-Mantelschicht 26 und die Kontaktschicht 30. Die Schichten 22, 24,26, 28 bilden den horizontalen Wellenleiter für das Licht der Pumpwellenlänge. Der dritte Bragg-Spiegel 12 und vierte Bragg-Spiegel 13 erstrecken sich über die Schichten 26, 30 und den oberen Bereich von Schicht 22. Zur Anpassung der Reflektivität der Bragg-Spiegel 12, 13 sind auf die planaren Kanten des Halbleiters zusätzlich dielektrische Schichten 50 aufgebracht. Die vertikale Kavität wird durch den ersten Bragg-Spiegel 18 und den beabstandeten zweiten Bragg-Spiegel 20 ausgebildet. Im Bereich des Lichtaustritts sind die Schichten 26 und 30 entfernt. Die Halbleiteroberfläche im Lichtaustrittsbereich ist mit einer dielektrischen Schutzschicht (40) versehen.

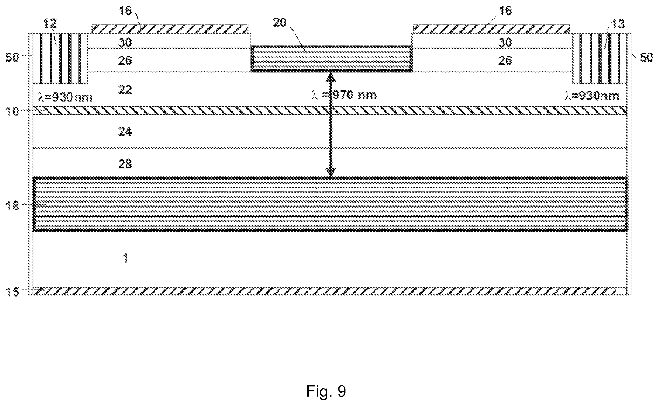

Fig. 9 zeigt den Querschnitt in der Ebene der Strahlausbreitung in beiden Kavitäten eines zweiten Ausführungsbeispieles C eines TCSEL. Typ C ist im Vergleich zu Typ B dadurch gekennzeichnet, dass der zweite Bragg-Spiegel 20 die dielektrische Schutzschicht ersetzt. Bei entsprechendem Design des ersten Bragg-Spiegels 18 kann dieser die n-Mantelschicht 28 ersetzen.

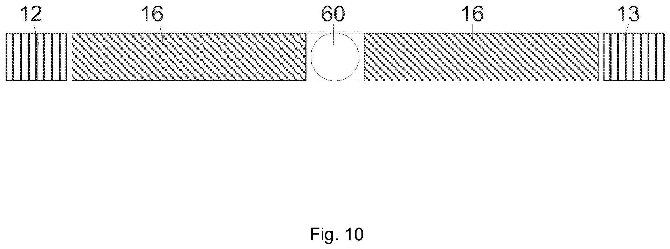

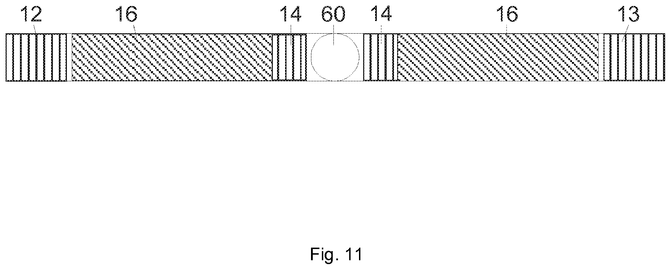

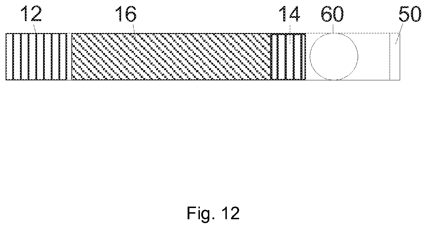

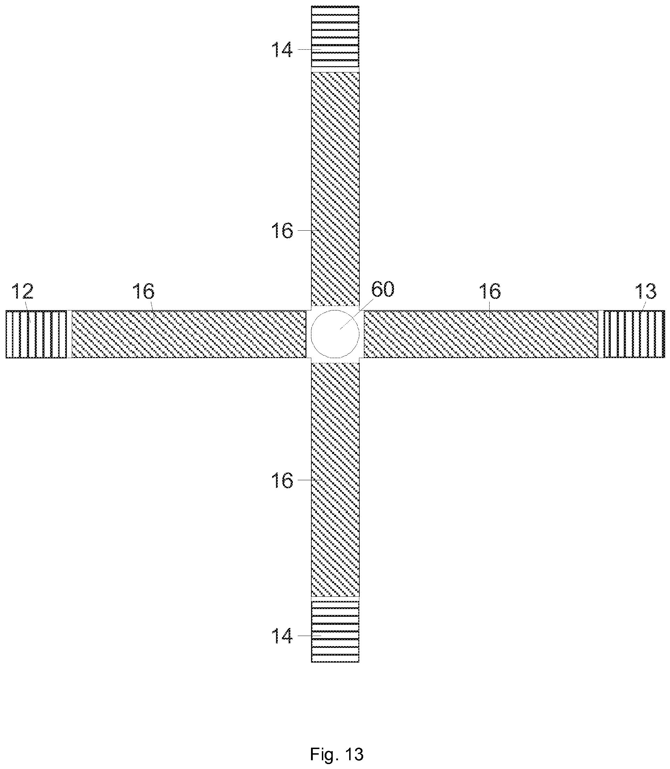

Fig. 10-13 zeigen schematisch die Draufsichten von vier bevorzugten Pumpkonfigurationen. Bei Typ 1 (Fig. 10) ist der VCSEL mittig in der Pumplaserkavität angeordnet. Typ 2 (Fig. 11) unterscheidet sich von Typ 1 dadurch, dass am Übergang Pumplaser-VCSEL weitere DBR-Reflektoren 14 eingebracht sind, um die Stabiltät der Lasermode im Pumpresonator zu verbessern. In Typ 3 (Fig. 12) wird der VCSEL nur von einer Seite gepumpt. In Typ 4 (Fig. 13) befindet sich der VCSEL in einer gekreuzten Kavität, um die Pumpleistung zu erhöhen.

Im Folgenden werden typische Zusammensetzungen für die bevorzugt verwendeten Schichten aufgeführt:
1 Substrat: bevorzugt n-GaAs
10 aktives Medium: bevorzugt ein bis fünf 5-15nm dicken InGaAs-Quantentopfschichten in 5-20nm dicken GaAs-Barrierenschichten
12 Bragg-Reflektor: in Epitaxieschichten geätztes Gitter
13 Bragg-Reflektor: in Epitaxieschichten geätztes Gitter
14 Bragg-Reflektor: in Epitaxieschichten geätztes Gitter
15 elektrischer Kontakt: Schichtfolge zur Erzeugung eines guten ohmschen Kontaktes
16 elektrischer Kontakt: Schichtfolge zur Erzeugung eines guten ohmschen Kontaktes
18 Bragg-Reflektor: λ/4 Schichtfolge bevorzugt aus im Wechsel angeordneten n-Al_{X}Ga_{1-X}As (X= 0-0.5) und n-Al_{Y}Ga_{1-Y}As (Y= 0.6-1)
20 Bragg-Reflektor: λ/4 Schichtfolge bevorzugt aus im Wechsel angeordneten Al_{X}Ga_{1-X}As (X= 0-0.5) und Al_{Y}Ga_{1-Y}As (Y= 0.6-1)
22 erste halbleitende Schicht: bevorzugt gering p-dotiertes 300-1000nm AIGaAs mit 20-50% Al-Anteil
24 zweite halbleitende Schicht: bevorzugt gering n-dotiertes 300-1000nm AIGaAs mit 20-50% Al-Anteil
26 dritte halbleitende Schicht: bevorzugt p-dotiertes 500-1000nm AlGaAs mit 30-95% Al-Anteil
28 vierte halbleitende Schicht: bevorzugt n-dotiertes 500-1000nm AlGaAs mit 30-95% Al-Anteil
30 fünfte halbleitende Schicht: bevorzugt hochdotiertes p-GaAs
40 dielektrische Schutzschicht: bevorzugt SiN

Die Herstellung des Verbindungshalbleiterschichtpaketes erfolgt vorzugsweise mittels MBE (molcular beam epitaxy) oder bevorzugt mittels MOVPE (metall-organic vapour phase epitaxy).

Die Herstellung des dritten Bragg-Spiegels und des vierten Bragg-Spiegels erfolgt vorzugsweise durch Erzeugung von streifenförmigen Lackschichten als Ätzmaskierung mittels Projektionslithographie, holographischer Lithographie, Elektronenstrahl-Lithographie oder Phasenmaskenlithographie. Die Halbleiterstrukturierung erfolgt vorzugsweise mittels Ätzung mit Säuren oder bevorzugt mittels aktiver Ionen (RIE: Reactive Ion Etching).

Die Öffnung der Lichtaustrittsfläche bei den TCSEL-Typen B-C erfolgt vorzugsweise ebenfalls mittels Ätzung mit Säuren oder bevorzugt mittels aktiver Ionen. Da bei Typ C die Ätztiefe die Kavitätslänge bestimmt, kann bei der Epitaxie der Schichten 22 und 26 eine Ätzstoppschicht bevorzugt aus InGaP eingefügt werden.

Alle anderen Herstellungsschritte wie vorzugsweise CVD (chemical vapour deposition) für Dielektrika, Elektronenstrahlverdampfung für Metallschichten und die zur Strukturierung notwendige Photolithograhie entsprechen dem Stand der Technik der Verbindungshalbleitertechnologie.

Der dritte Bragg-Spiegel und vierte Bragg-Spiegel werden bevorzugt als Oberflächengitter ausgebildet. Alternativ ist es möglich, den dritten Bragg-Spiegel und vierten Bragg-Spiegel auch als vergrabene Gitter näher an der aktiven Zone auszubilden. Dies würde jedoch einen höheren technologischen Aufwand bedeuten.

### Bezugszeichenliste

- 1: Substrat
- 10: aktives Medium
- 12: Bragg-Reflektor
- 13: Bragg-Reflektor
- 14: Bragg-Reflektor
- 15: elektrischer Kontakt
- 16: elektrischer Kontakt
- 18: Bragg-Reflektor
- 20: Bragg-Reflektor
- 22: erste halbleitende Schicht
- 24: zweite halbleitende Schicht
- 26: dritte halbleitende Schicht
- 28: vierte halbleitende Schicht
- 30: fünfte halbleitende Schicht
- 40: dielektrische Schicht
- 50: dielektrische Schicht
- 60: Lichtaustrittsöffnung

## Patentansprüche

1. Vertical-Cavity Surface-Emitting Laser mit einem streifenförmigen, aktiven Medium (10) mit einem Emissionsmaximum bei einer ersten Wellenlänge (λ1),
wobei ein erster Reflektor (18) unterhalb des streifenförmigen, aktiven Mediums (10) und ein zweiter Reflektor (20) oberhalb des streifenförmigen, aktiven Mediums (10) angeordnet sind und der erste Reflektor (18) dem zweiten Reflektor (20) gegenüberliegt, wobei der erste Reflektor (18) und der zweite Reflektor (20) ein Reflexionsmaximum im Bereich der ersten Wellenlänge (λ1) aufweisen,
wobei ein dritter Reflektor (12) und ein vierter Reflektor (13) jeweils seitlich über oder neben dem streifenförmigen, aktiven Medium (10) angeordnet sind, wobei der dritte Reflektor (12) dem vierten Reflektor (13) gegenüberliegt, und wobei der dritte Reflektor (12) und der vierte Reflektor (13) ein Reflexionsmaximum im Bereich einer zweiten Wellenlänge (λ2) aufweisen,
wobei das eine streifenförmige, aktive Medium (10) auch zur Erzeugung von Strahlung bei der zweiten Wellenlänge dient,
wobei die erste Wellenlänge (λ1) größer als die zweite Wellenlänge (λ2) ist und die Differenz zwischen der ersten Wellenlänge und der zweiten Wellenlänge zwischen 20nm und 45nm beträgt, und
wobei die Bandbreite des dritten Reflektors (12) und des vierten Reflektors (13), innerhalb der die Reflektivität mehr als 50% der maximalen Reflektivität beträgt, kleiner als 5nm ist.

2. Vertical-Cavity Surface-Emitting Laser nach Anspruch 1,
**dadurch gekennzeichnet, dass**
mindestens einer der Reflektoren aus der Gruppe: erster Reflektor (18), zweiter Reflektor (20), dritter Reflektor (12) und vierter Reflektor (13) als Bragg-Reflektor ausgebildet ist.

3. Vertical-Cavity Surface-Emitting Laser nach Anspruch 1 oder 2,
**dadurch gekennzeichnet, dass**
das streifenförmige, aktive Medium (10) aus einem Schichtpaket einer Dicke zwischen 5 nm und 100 nm besteht und/oder eine Länge zwischen 250 µm und 2 mm aufweist.

4. Vertical-Cavity Surface-Emitting Laser nach Anspruch 1 oder 2,
**dadurch gekennzeichnet, dass**
das streifenförmige, aktive Medium (10) aus mehreren gleichen oder unterschiedlichen Schichtpaketen mit Dicken zwischen 5 nm und 100 nm besteht und/oder eine Länge zwischen 250 µm und 2 mm aufweist.

5. Vertical-Cavity Surface-Emitting Laser nach einem der vorhergehenden Ansprüche,
**dadurch gekennzeichnet, dass**
der dritte Reflektor (12) und der vierte Reflektor (13) das streifenförmige, aktive Medium (10) direkt kontaktieren.

6. Vertical-Cavity Surface-Emitting Laser nach einem der vorhergehenden Ansprüche,
**dadurch gekennzeichnet, dass**
der Laser genau ein streifenförmiges, aktives Medium (10) aufweist.

7. Vertical-Cavity Surface-Emitting Laser nach einem der vorhergehenden Ansprüche,
**dadurch gekennzeichnet, dass**
das streifenförmige, aktive Medium (10) innerhalb einer ersten Kavität zwischen dem ersten Reflektor (18) und dem zweiten Reflektor (20) angeordnet ist.

8. Vertical-Cavity Surface-Emitting Laser nach einem der vorhergehenden Ansprüche,
**dadurch gekennzeichnet, dass**
das streifenförmige, aktive Medium (10) innerhalb einer zweiten Kavität zwischen dem dritten Reflektor (12) und dem vierten Reflektor (13) angeordnet ist, oder dass der dritte Reflektor (12) und der vierte Reflektor (13) zur Ausbildung einer zweiten Kavität oberhalb des streifenförmigen, aktiven Mediums (10) angeordnet sind.

9. Vertical-Cavity Surface-Emitting Laser nach einem der vorhergehenden Ansprüche,
**dadurch gekennzeichnet, dass**
das streifenförmige, aktive Medium (10) an seiner Oberseite ein erstes Schichtpaket (22, 26, 30) aus einem halbleitenden Material direkt kontaktiert und an seiner Unterseite ein zweites Schichtpaket (24, 28) aus einem halbleitenden Material direkt kontaktiert, wobei das erste halbleitende Schichtpaket (22, 26, 30) in Bezug zum zweiten halbleitenden Schichtpaket (24, 28) eine Dotierung entgegengesetzter Polarität aufweist.

10. Vertical-Cavity Surface-Emitting Laser nach Anspruch 7,
**dadurch gekennzeichnet, dass**
der erste Reflektor (18) direkt auf dem zweiten halbleitenden Schichtpaket (24, 28) angeordnet ist, wobei der zweite Reflektor (20) vom ersten halbleitenden Schichtpaket (22, 26, 30) zur Ausbildung einer vertikalen, externen Kavität beabstandet ist.

11. Vertical-Cavity Surface-Emitting Laser nach Anspruch 5,
**dadurch gekennzeichnet, dass**
mindestens ein elektrischer Kontakt (16) zur Injektion von Ladungsträgern auf der zweiten halbleitenden Schicht (24) im Bereich seitlich oder unterhalb des zweiten Reflektors (20) angeordnet ist.

12. Vertical-Cavity Surface-Emitting Laser nach einem der Ansprüche 8 und 9,
**dadurch gekennzeichnet, dass**
mindestens ein elektrischer Kontakt (16) zur Injektion von Ladungsträgern auf dem ersten halbleitenden Schichtpaket (22, 26, 30) in einem Bereich angeordnet ist, der seitlich einer Projektion des zweiten Reflektors (20) in die Ebene des ersten halbleitenden Schichtpakets (22, 26, 30) entlang einer senkrecht zum ersten halbleitenden Schichtpaket (22, 26, 30) verlaufenden Achse liegt.

13. Vertical-Cavity Surface-Emitting Laser nach einem der vorhergehenden Ansprüche,
**dadurch gekennzeichnet, dass**
sich der dritte Reflektor (12) und der vierte Reflektor (13) jeweils über den gesamten elektrisch gepumpten Bereich seitlich einer Projektion des zweiten Reflektors (20) in die Ebene des ersten halbleitenden Schichtpakets (22, 26, 30) entlang einer senkrecht zum ersten halbleitenden Schichtpaket (22, 26, 30) verlaufenden Achse erstrecken.

14. Vertical-Cavity Surface-Emitting Laser nach einem der vorhergehenden Ansprüche,
**dadurch gekennzeichnet, dass**
der erste Reflektor (18) und der zweite Reflektor (20) jeweils eine Reflektivität von größer 99% für die erste Wellenlänge (λ1) aufweisen und/oder der dritte Reflektor (12) und der vierte Reflektor (13) jeweils eine Reflektivität von größer 60% für die zweite Wellenlänge (λ2) aufweisen und/oder die Reflektivität des ersten Reflektors (18) für die erste Wellenlänge (λ1) größer als die Reflektivität des zweiten Reflektors (20) für die erste Wellenlänge (λ1) ist.

## Claims

1. A vertical-cavity surface-emitting laser with a stripe-shaped active medium (10) having an emission maximum at a first wavelength (λ1),
wherein a first reflector (18) is arranged below the stripe-shaped active medium (10) and a second reflector (20) is arranged above the stripe-shaped active medium (10), and the first reflector (18) faces the second reflector (20), wherein the first reflector (18) and the second reflector (20) have a maximum reflection in the region of the first wavelength (λ1),
wherein a third reflector (12) and a fourth reflector (13) are each arranged on a side above or next to the stripe-shaped active medium (10), wherein the third reflector (12) faces the fourth reflector (13), and wherein the third reflector (12) and the fourth reflector (13) have a maximum reflection in the region of a second wavelength (λ2), wherein the one stripe-shaped active medium (10) also serves to generate radiation at
the second wavelength,
wherein the first wavelength (λ1) is greater than the second wavelength (λ2), and the difference between the first wavelength and the second wavelength is between 20 nm and 45 nm, and
wherein the bandwidth of the third reflector (12) and of the fourth reflector (13), within which the reflectivity is more than 50% of the maximum reflectivity, is less than 5 nm.

2. The vertical-cavity surface-emitting laser according to claim 1,
**characterized in that**
at least one of the reflectors from the group: the first reflector (18), the second reflector (20), the third reflector (12) and the fourth reflector (13) is configured as a Bragg reflector.

3. The vertical-cavity surface-emitting laser according to claim 1 or 2,
**characterized in that**
the stripe-shaped active medium (10) consists of a layer structure having a thickness between 5 nm and 100 nm and/or has a length between 250 µm and 2 mm.

4. The vertical-cavity surface-emitting laser according to claim 1 or 2,
**characterized in that**
the stripe-shaped active medium (10) consists of multiple identical or different layer structures with thicknesses between 5 nm and 100 nm and/or has a length between 250 µm and 2 mm.

5. The vertical-cavity surface-emitting laser according to any one of the preceding claims,
**characterized in that**
the third reflector (12) and the fourth reflector (13) directly contact the stripe-shaped active medium (10).

6. The vertical-cavity surface-emitting laser according to any one of the preceding claims,
**characterized in that**
the laser has exactly one stripe-shaped active medium (10).

7. The vertical-cavity surface-emitting laser according to any one of the preceding claims,
**characterized in that**
the stripe-shaped active medium (10) is arranged inside a first cavity between the first reflector (18) and the second reflector (20).

8. The vertical-cavity surface-emitting laser according to any one of the preceding claims,
**characterized in that**
the stripe-shaped active medium (10) is arranged inside a second cavity between the third reflector (12) and the fourth reflector (13), or that the third reflector (12) and the fourth reflector (13) are arranged above the stripe-shaped active medium (10) to form a second cavity.

9. The vertical-cavity surface-emitting laser according to any one of the preceding claims, **characterized in that**
the stripe-shaped active medium (10) directly contacts at its top surface a first layer structure (22, 26, 30) made of a semiconducting material and directly contacts at its bottom surface a second layer structure (24, 28) made of a semiconducting material, wherein the first semiconducting layer structure (22, 26, 30) has a doping of opposite polarity with respect to the second semiconducting layer structure (24, 28).

10. The vertical-cavity surface-emitting laser according to claim 7,
**characterized in that**
the first reflector (18) is arranged directly on the second semiconducting layer structure (24, 28), wherein the second reflector (20) is spaced apart from the first semiconducting layer structure (22, 26, 30) to form a vertical external cavity.

11. The vertical-cavity surface-emitting laser according to claim 5,
**characterized in that**
at least one electric contact (16) for injection of carriers is arranged on the second semiconducting layer (24) in the region on the side of or below the second reflector (20).

12. The vertical-cavity surface-emitting laser according to any one of claims 8 and 9, **characterized in that**
at least one electric contact (16) for injection of carriers is arranged on the first semiconducting layer structure (22, 26, 30) in a region which is located on the side of a projection of the second reflector (20) into the plane of the first semiconducting layer structure (22, 26, 30) along an axis extending perpendicularly with respect to the first semiconducting layer structure (22, 26, 30).

13. The vertical-cavity surface-emitting laser according to any one of the preceding claims, **characterized in that**
the third reflector (12) and the fourth reflector (13) each extend over the entire electrically pumped region on the side of a projection of the second reflector (20) into the plane of the first semiconducting layer structure (22, 26, 30) along an axis extending perpendicular with respect to the first semiconducting layer structure (22, 26, 30).

14. The vertical-cavity surface-emitting laser according to any one of the preceding claims, **characterized in that**
the first reflector (18) and the second reflector (20) each have a reflectivity of greater than 99% for the first wavelength (λ1) and/or the third reflector (12) and the fourth reflector (13) each have a reflectivity of greater than 60% for the second wavelength (λ2) and/or the reflectivity of the first reflector (18) for the first wavelength (λ1) is greater than the reflectivity of the second reflector (20) for the first wavelength (λ1).

## Revendications

1. Laser à émission par la surface et à cavité verticale, avec un milieu actif en forme de bandes (10) présentant un maximum d'émission à une première longueur d'onde (λ1), dans lequel un premier réflecteur (18) est disposé en dessous du milieu actif en forme de bandes (10) et un deuxième réflecteur (20) est disposé au-dessus du milieu actif en forme de bandes (10) et le premier réflecteur (18) fait face au deuxième réflecteur (20), dans lequel le premier réflecteur (18) et le deuxième réflecteur (20) présentent un maximum d'émission dans la plage de la première longueur d'onde (λ1), dans lequel un troisième réflecteur (12) et un quatrième réflecteur (13) sont disposés respectivement latéralement au-dessus ou à côté du milieu actif en forme de bandes (10), dans lequel le troisième réflecteur (12) fait face au quatrième réflecteur (13), et dans lequel le troisième réflecteur (12) et le quatrième réflecteur (13) présentent un maximum d'émission dans la plage d'une seconde longueur d'onde (λ2),
dans lequel ledit milieu actif en forme de bandes (10) sert aussi à générer un rayonnement à la seconde longueur d'onde,
dans lequel la première longueur d'onde (λ1) est plus grande que la seconde longueur d'onde (λ2) et la différence entre la première longueur d'onde et la seconde longueur d'onde est comprise entre 20 nm et 45 nm, et
dans lequel la largeur de bande du troisième réflecteur (12) et du quatrième réflecteur (13), à l'intérieur de laquelle la réflectivité atteint plus de 50% de la réflectivité maximale, est inférieure à 5 nm.

2. Laser à émission par la surface et à cavité verticale selon la revendication 1, **caractérisé en ce**
**qu'**au moins l'un des réflecteurs issu du groupe : premier réflecteur (18), deuxième réflecteur (20), troisième réflecteur (12) et quatrième réflecteur (13) est conçu sous la forme d'un réflecteur de Bragg.

3. Laser à émission par la surface et à cavité verticale selon la revendication 1 ou 2, **caractérisé en ce que**
le milieu actif en forme de bandes (10) consiste en un ensemble de couches d'une épaisseur comprise entre 5 nm et 100 nm et/ou présente une longueur comprise entre 250 µm et 2 mm.

4. Laser à émission par la surface et à cavité verticale selon la revendication 1 ou 2, **caractérisé en ce que**
le milieu actif en forme de bandes (10) consiste en plusieurs ensembles de couches identiques ou différents d'épaisseurs comprises entre 5 nm et 100 nm et/ou présente une longueur comprise entre 250 µm et 2 mm.

5. Laser à émission par la surface et à cavité verticale selon l'une quelconque des revendications précédentes, **caractérisé en ce que**
le troisième réflecteur (12) et le quatrième réflecteur (13) sont en contact direct avec le milieu actif en forme de bandes (10).

6. Laser à émission par la surface et à cavité verticale selon l'une quelconque des revendications précédentes, **caractérisé en ce que**
le laser présente exactement un milieu actif en forme de bandes (10).

7. Laser à émission par la surface et à cavité verticale selon l'une quelconque des revendications précédentes, **caractérisé en ce que**
le milieu actif en forme de bandes (10) est disposé à l'intérieur d'une première cavité entre le premier réflecteur (18) et le deuxième réflecteur (20).

8. Laser à émission par la surface et à cavité verticale selon l'une quelconque des revendications précédentes, **caractérisé en ce que**
le milieu actif en forme de bandes (10) est disposé à l'intérieur d'une seconde cavité entre le troisième réflecteur (12) et le quatrième réflecteur (13), ou que le troisième réflecteur (12) et le quatrième réflecteur (13) sont disposés au-dessus du milieu actif en forme de bandes (10) pour constituer une seconde cavité.

9. Laser à émission par la surface et à cavité verticale selon l'une quelconque des revendications précédentes, **caractérisé en ce que**
le milieu actif en forme de bandes (10) est en contact direct au niveau de sa face supérieure avec un premier ensemble de couches (22, 26, 30) à base d'un matériau semi-conducteur et au niveau de sa face inférieure avec un second ensemble de couches (24, 28) à base d'un matériau semi-conducteur, dans lequel le premier ensemble de couches semi-conductrices (22, 26, 30) présente un dopage de polarité opposée par rapport au second ensemble de couches semi-conductrices (24, 28).

10. Laser à émission par la surface et à cavité verticale selon la revendication 7, **caractérisé en ce que**
le premier réflecteur (18) est disposé directement sur le second ensemble de couches semi-conductrices (24, 28), dans lequel le deuxième réflecteur (20) est espacé du premier ensemble de couches semi-conductrices (22, 26, 30) pour constituer une cavité externe verticale.

11. Laser à émission par la surface et à cavité verticale selon la revendication 5, **caractérisé en ce**
**qu'**au moins un contact électrique (16) est disposé dans la zone située latéralement ou en dessous du deuxième réflecteur (20) pour injecter des porteurs de charge sur la seconde couche semi-conductrice (24).

12. Laser à émission par la surface et à cavité verticale selon l'une des revendications 8 et 9, **caractérisé en ce**
**qu'**au moins un contact électrique (16) est disposé pour injecter des porteurs de charge sur le premier ensemble de couches semi-conductrices (22, 26, 30) dans une zone, qui se trouve latéralement par rapport à une projection du deuxième réflecteur (20) dans le plan du premier ensemble de couches semi-conductrices (22, 26, 30) le long d'un axe évoluant à la perpendiculaire du premier ensemble de couches semi-conductrices (22, 26, 30).

13. Laser à émission par la surface et à cavité verticale selon l'une quelconque des revendications précédentes, **caractérisé en ce que**
le troisième réflecteur (12) et le quatrième réflecteur (13) s'étendent respectivement sur toute la zone soumise au pompage électrique latéralement par rapport à une projection du deuxième réflecteur (20) dans le plan du premier ensemble de couches semi-conductrices (22, 26, 30) le long d'un axe évoluant à la perpendiculaire du premier ensemble de couches semi-conductrices (22, 26, 30).

14. Laser à émission par la surface et à cavité verticale selon l'une quelconque des revendications précédentes, **caractérisé en ce que**
le premier réflecteur (18) et le deuxième réflecteur (20) présentent respectivement une réflectivité supérieure à 99% pour la première longueur d'onde (λ1) et/ou le troisième réflecteur (12) et le quatrième réflecteur (13) présentent respectivement une réflectivité supérieure à 60% pour la seconde longueur d'onde (λ2) et/ou la réflectivité du premier réflecteur (18) pour la première longueur d'onde (λ1) est supérieure à la réflectivité du deuxième réflecteur (20) pour la première longueur d'onde (λ1).
